# EUROPEAN PATENT APPLICATION

(11) **EP 2 838 016 A1**
(43) Date of publication of application: **18.02.2015**
(21) Application number: 14181031.7
(22) Date of filing: 14.08.2014
(51) Int. Cl.: G06F 9/44, G06F 9/45

(54) **Automated augmented model extension for robust system design**

(30) Priority: 15.08.2013 US 201313967503
(71) Applicant: Palo Alto Research Center Incorporated, Palo Alto, California 94304 (US)
(72) Inventor: Saha, Bhaskar, Redwood City, CA California 94065 (US); Janssen, JR., William C., Mountain View, CA California 94043 (US); Bobrow, Daniel G., Palo Alto, CA California 94301 (US); Kurtoglu, Tolga, San Jose, CA California 95125 (US); De Kleer, Johan, Los Altos, CA California 94024 (US)
(74) Representative: Lord, Michael

(57) **Abstract**

A method is provided for automatically generating an augmented model of a cyber-physical component. Cyber-physical components are built from or depend upon the synergy computational and physical components. The method includes: reading an input model (22) into a processor (10), the input model describing a nominal mode of operation for a physical component modeled by the input model; parsing with the processor the input model to generate a parse thereof; analyzing with the processor the parse of the input model; and automatically writing with the processor an augmented model (42) for the physical component from the input model based on the analysis, the augmented model describing the nominal mode of operation for the modeled physical component and at least one alternate mode of operation for the modeled physical component which is different from the nominal mode of operation. The augmented component models can be used to provide analyses of the behavior of faulted systems, including diagnosis, reliability, resiliency to faults and maintainability.

## Description

### BACKGROUND

The present inventive subject matter relates generally to the art of cyber-physical component and/or system modeling. Particular but not exclusive relevance is found in connection with object-oriented and/or other like modeling computer languages, e.g., such as Modelica, etc. The present specification accordingly makes specific reference thereto at times. However, it is to be appreciated that aspects of the present inventive subject matter are also equally amenable to other like applications and/or environments.

Modeling languages, e.g., such as Modelica, are commonly used to generate virtual models of and/or to simulate physical components and/or systems for design, analysis and/or testing purposes. For example, the physical systems and/or components that are modeled may be fairly complex or rather simple and can include, e.g., electrical circuits or automotive vehicles or other physical systems. For example, the open source Modelica Standard Library (MSL) includes models of approximately 1280 components in domains, e.g., such as electronics, mechanics and fluids. Cyber-physical components are built from or depend upon the synergy of computational and physical components, such as system controllers that implement control software on hardware platforms, as found in vehicles, assembly lines and other engineered systems. For example, the Modelica_LinearSystems2 library includes models for continuous and discrete controllers. The MSL itself includes models for different variants of Proportional, Integral and Differential (PID) controllers. These Modelica models and the like have come to be widely used more and more in various projects. In this disclosure, we use the terms "physical component" to mean either or both "physical" and "cyber-physical component".

In practice, however, the MSL models and the like generally describe and/or represent only one mode of operation for the component being modeled, namely, the nominal or correct behavior of the component being modeled. That is to say, such models commonly do not describe faulty or other non-nominal behaviors. For example, a fault mode may be a short or open circuit or a motor that fails to run or a slipping brake, etc. Any number of difference mechanisms, e.g., such as wear, material fatigue, corrosion, etc., may lead to the faulty operation of a modeled component. Often, it may be desirable to test and/or analyze components operating in faulty or otherwise non-nominal modes, e.g., for diagnostic purposes. However, insomuch as conventional MSL models and the like generally do not describe such faulty and/or otherwise non-nominal modes, diagnostics and/or other testing of modeled components operating in such faulty and/or otherwise non-nominal modes can be problematic.

One option is to manually create models to represent each of the fault and/or otherwise non-nominal modes of a component under consideration. However, in complex systems with numerous components, manual creation of all the relevant fault models is impractical in view of the relatively larger number of non-nominal behaviors that one would have to model. Moreover, the manual creation of models to represent non-nominal behaviors is prone to human error and/or oversight as well as being labor intensive. Consequently, for complex systems, the coverage of fault analyses at the design stage is seldom comprehensive. In some cases this has led to system failure during operation, sometimes with catastrophic consequences.

Accordingly, a new and/or improved method and/or system or apparatus is disclosed for automatically and/or semi-automatically generating component models including non-nominal behavior mode which addresses the above-referenced problem(s) and/or others. Additionally, it allows investigation of the effect of component fault at the system level that may possibly be used to improve the system design in terms of robustness, resiliency and reliability.

### SUMMARY

This summary is provided to introduce concepts related to the present inventive subject matter. The summary is not intended to identify essential features of the claimed subject matter nor is it intended for use in determining or limiting the scope of the claimed subject matter. The embodiments described below are not intended to be exhaustive or to limit the invention to the precise forms disclosed in the following detailed description. Rather, the embodiments are chosen and described so that others skilled in the art may appreciate and understand the principles and practices of the present inventive subject matter.

In accordance with one embodiment, a method is provided for automatically generating an augmented model of a physical component. The method includes: reading an input model into a processor, the input model describing a nominal mode of operation for a physical component modeled by the input model; parsing with the processor the input model to generate a parse thereof; analyzing with the processor the parse of the input model; and automatically writing with the processor an augmented model for the physical component from the input model based on the analysis, the augmented model describing the nominal mode of operation for the modeled physical component and at least one alternate mode of operation for the modeled physical component which is different from the nominal mode of operation. In the context of cyber-physical systems like a PID controller, the method comprises detecting patterns of different controller types and changing the controller gains, delays, or other parameters to represent non-nominal operational conditions.

In accordance with another embodiment, a system is provided for automatically generating an augmented model of a physical component. The system includes a processor operative to: read in an input model, the input model describing a nominal mode of operation for a physical component modeled by the input model; parse the input model to generate a parse thereof; analyze the parse of the input model; and automatically write an augmented model for the physical component from the input model based on the analysis, the augmented model describing the nominal mode of operation for the modeled physical component and at least one alternate mode of operation for the modeled physical component which is different from the nominal mode of operation.

Numerous advantages and benefits of the inventive subject matter disclosed herein will become apparent to those of ordinary skill in the art upon reading and understanding the present specification. It is to be understood, however, that the detailed description of the various embodiments and specific examples, while indicating preferred and/or other embodiments, are given by way of illustration and not limitation. Many changes and modifications within the scope of the present invention may be made without departing from the spirit thereof, and the invention includes all such modifications.

### BRIEF DESCRIPTION OF THE DRAWING(S)

The following detailed description makes reference to the figures in the accompanying drawings. However, the inventive subject matter disclosed herein may take form in various components and arrangements of components, and in various steps and arrangements of steps. The drawings are only for purposes of illustrating exemplary and/or preferred embodiments and are not to be construed as limiting. Further, it is to be appreciated that the drawings may not be to scale.
FIGURE 1 is a diagrammatic illustration showing an exemplary model transformation system suitable for practicing aspects of the present inventive subject matter.
FIGURE **2** is a flow chart showing an exemplary method for performing a model transformation process in accordance with aspects of the present inventive subject matter.

### DETAILED DESCRIPTION OF THE EMBODIMENT(S)

For clarity and simplicity, the present specification shall refer to structural and/or functional elements, relevant standards, algorithms and/or protocols, and other components, algorithms, methods and/or processes that are commonly known in the art without further detailed explanation as to their configuration or operation except to the extent they have been modified or altered in accordance with and/or to accommodate the preferred and/or other embodiment(s) presented herein. Moreover, the apparatuses and methods disclosed in the present specification are described in detail by way of examples and with reference to the figures. Unless otherwise specified, like numbers in the figures indicate references to the same, similar or corresponding elements throughout the figures. It will be appreciated that modifications to disclosed and described examples, arrangements, configurations, components, elements, apparatuses, methods, materials, etc. can be made and may be desired for a specific application. In this disclosure, any identification of specific materials, techniques, arrangements, etc. are either related to a specific example presented or are merely a general description of such a material, technique, arrangement, etc. Identifications of specific details or examples are not intended to be, and should not be, construed as mandatory or limiting unless specifically designated as such. Selected examples of apparatuses and methods are hereinafter disclosed and described in detail with reference made to the figures.

In general, there is disclosed herein a method and/or system which is operative to augment models of physical system components with fault and/or other non-nominal modes. Suitably, models including the fault and/or other non-nominal modes are automatically or semi-automatically generated from models of the components which otherwise describe only the nominal or correct behaviors of the components. Note, as used herein FAME is an acronym for Fault-Augmented Model Extension. However, it is to be appreciated that the augmented models may be extended as described herein to include other alternate modes that are not "fault" related strictly speaking, but are rather related to other non-nominal or alternate operating modes.

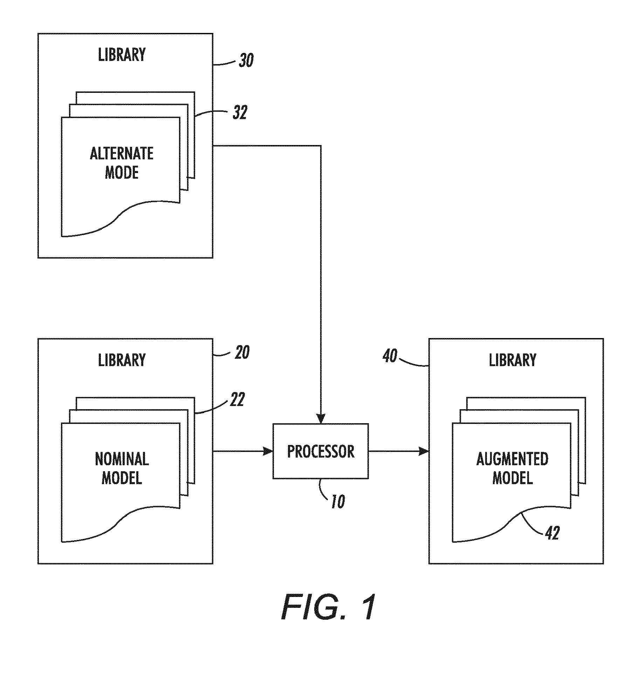

With reference now to FIGURE 1, there is shown in general a computer 10 or other like processor which executes or otherwise performs a model transformation process, e.g., either automatically or semi-automatically. Input thereto is a first library 20 of nominal component models 22. For example, the library 20 may include a collection of models 22, in which each model 22 describes and/or otherwise represents a physical component, e.g., including the operation and/or behavior of the component. Suitably, the library 20 may include one or more such models 22, e.g., representing components that are to be employed and/or interact together in a system, or the library 20 may include some other suitable collection of such models 22. In practice, each model 22 in the input library 20 may comprise and/or be represented by lines of code (e.g., written in the Modelica language or another such suitable language) or the like stored in a file or otherwise in a suitable memory or other data storage device accessible by the computer or processor 10. Suitably, at least one of the models 22 (but alternately more or all of the models 22) in the library 20 describes or otherwise simulates only a nominal operation and/or behavior of the physical component modeled thereby, e.g., such nominal operation and/or behavior may correspond to the correct operation and/or behavior of the modeled component. In one simple example, the library 20 may include only one model 22, and in more complex examples, it may include a great many models 22.

As another input, a second library 30 may include a collection of salient alternate modes and/or mechanisms 32 applicable to the modeled components of the library 20. For example, each alternate mode and/or mechanism 32 of the library 30 may describe and/or represent a fault mode and/or mechanism or some other non-nominal or alternate mode of operation and/or behavior. In practice, each alternate mode 32 may be applicable to one or more modeled components in the library 20, while potentially not being applicable to others. For example, a short circuit fault mode may be applicable to a number of different electronic components (e.g., such as a capacitor and/or inductor), while not being applicable to mechanical components (e.g., such as a brake). Suitably, each alternate mode 32 in the input library 30 may comprise and/or be represented by lines of code (e.g., written in the Modelica language or another such suitable language) or the like stored in a file or otherwise in a suitable memory or other data storage device accessible by the computer or processor 10. For example, a fault mechanism can be used to express an underlying cause of a fault, while a fault mode can be used to express the abnormal operation or behavior of a component being modeled. Consider, for purposes of illustration, the exemplary fault mechanisms of a rusty shaft and a disconnected lead wire in relation to a motor which is being modeled. The corresponding fault modes resulting from the aforementioned mechanisms may be a shaft that is harder to turn (i.e., as compared to when the motor is otherwise operating normally) and a motor that simply does not run, respectively.

In one suitable embodiment, for example, fault modes and mechanisms may be captured and/or otherwise identified for each subject component being modeled. These may be organized, optionally along with fault probabilities, in a suitable taxonomy so that corresponding behavioral models can be built consistently. Accordingly, a fault mechanism behavior schema may in turn be developed in view of the aforementioned taxonomy. For example, the schema may define faulty behavior at the highest abstraction level in a generic sense and use the concept of inheritance to specify behavior for the lower-level fault mechanisms. This approach allows for flexibility in defining behavior for subclasses of fault mechanisms. Consider the case of a fault mechanism identified as "wear." This may represent a high-level category of different subclasses of wear, e.g., such as abrasive, impact or corrosive wear. Suitably then, the subclasses (of wear in this example) inherit and expands upon the higher-level behavior. For example, the behavior of wear representing a loss of material is expanded to include, e.g., the frictional behavior in the subclass of abrasive wear. The result of this process is that fault modes for different components can call upon the same fault mechanism, i.e., underlying faulty behavioral model. Moreover, these subclasses may cover the expression of a fault mechanism in different domains, e.g., such as mechanical, hydraulic, electronic, etc.

Of course, more broadly, an alternate mode may not represent faulty operation and/or behavior at all but rather may simply represent some other non-nominal operation and/or behavior of the component being modeled.

In any event, the processor 10 generates and/or otherwise outputs a library 40 of augmented component models 42. In practice, each model 42 in the output library 40 may comprise and/or be represented by lines of code (e.g., written in the Modelica language or another such suitable language) or the like output to a file or otherwise which is stored in a suitable memory or other data storage device accessible by the computer or processor 10. Suitably, in accordance with the model transformation process executed by the computer and/or processor 10, an augmented component model 42 is output for each input nominal component model 22 from the library 20, with the augmented component models 42 including a description and/or representation of not only the nominal operation and/or behavior of the modeled component but also including a description and/or representation of one or more or all of the alternate modes of operation and/or behavior applicable to the component being modeled. Suitably, the output augmented component models 42 of the library 40 are fully compatible with their corresponding input nominal component models 22, e.g., in terms of their interfaces, inputs, outputs and parameters. Accordingly, for example, the augmented component models 42 may simply be plugged-in to and/or replace the nominal component models 22 for testing and/or analysis of fault and/or other alternative modes of operation and/or behavior of various components.

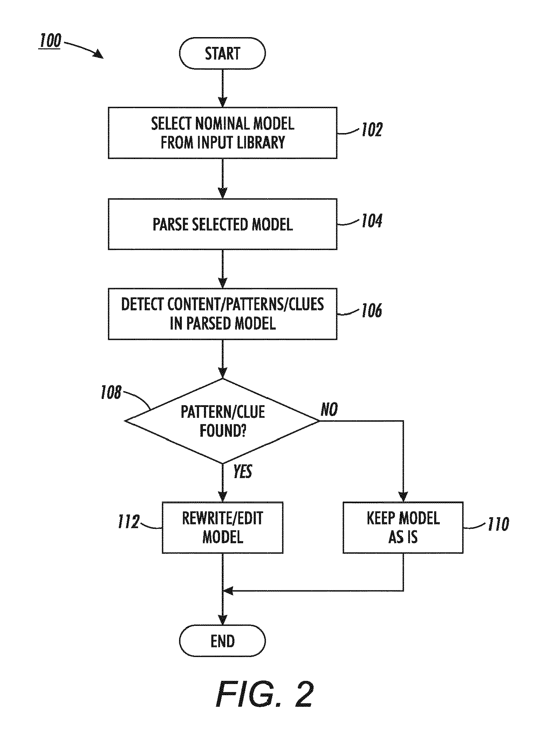

In one exemplary embodiment, the computer and/or processor 10 may execute a computer program or the like (e.g., stored in a suitable memory or other data storage device accessible by the computer/processor 10) to carry out the aforementioned model transformation process. FIGURE 2 is a flow chart illustrating steps of one suitable embodiment of the model transformation process 100. Optionally, the aforementioned program executed by the computer/processor 10 may be written in a general-purpose, class-based, object-oriented computer programming language, e.g., such as a Java or the like, which incorporates the JModelica platform or the like and the Java/JastAdd parser or the like. Suitably, the program runs over the input library 20 and recognizes those nominal component models 22 which are susceptible the various faults and/or alternate modes 32 of the library 30, e.g., by identifying specified patterns associated with the respective alternate modes 32 in the variables, equations and/or other content of the models 22. That is to say, if the variables, equations and/or other content of a given model 22 match (e.g., within a given tolerance) a specific pattern which is associated with a given alternate mode 32, then that alternate mode 32 is deemed applicable to the given model 22. Consequently, the model 22 is in essence rewritten to include a description of the applicable alternate mode 32, and the new augmented model 42 is output.

Referring now more specifically to FIGURE 2, the model transformation process 100 suitably begins at step 102, with the reading in of one of the models 22 from the library 20.

At step 104, the model 22 is parsed, and at step 106, the parsed model is examined and/or analyzed to look for specified content, patterns and/or clues therein which are associated with an alternative mode 32. In practice, a given model 22 will generally comprises one or more lines of code, including, e.g., equations, parameters, variables and/or other content, which defines the component being modeled along with its nominal operation and/or behavior. From this content, clues and/or patterns can be detected and/or discerned which match (e.g., within some degree of tolerance) certain content, clues and/or patterns associated with faults and/or other non-nominal or alternate modes. To illustrate, the content may include elements, clues or patterns which suggest that a given model 22 describes an electrical component, e.g., such as a capacitor. Indeed, the model 22 may include an equation or parameter or other content from which it can be determined that the model 22 is in fact a capacitor. To continue with the example, it may be known that this type of component, i.e., an electrical component in general and more specifically a capacitor, is susceptible to certain faults and/or certain alternate modes are applicable thereto, e.g., a short or an open circuit, etc. That is to say, the content of the model 22 sufficiently matches a pattern associated with the respective fault and/or alternate mode 32.

At decision step 108, if no pattern and/or clues are found which sufficiently match those sought, then the process 100 branches to step 110, otherwise if a pattern is found, then the process 100 continues to step 112.

At step 110, the model 22 is essentially left unaltered. That is to say, the model 22 may be essentially left as is. In this case, the corresponding model 42 in the output library 40 will be essentially the same as the input model 22.

Conversely, at step 112, the model 22 is rewritten and/or edited into a new model 42 so as to describe, not only the nominal mode of operation originally contained in the model 22, but also to describe the alternate mode associated with matched pattern.

In practice, it is to be appreciated that suitably each model 22 of the input library 20 is so processed, e.g., in turn or in parallel. Additionally, it is to be appreciated that in practice each model 22 may be susceptible to zero or one or more of the faults and/or alternate modes 32 described in the library 30. That is to say, the content of the model 22 may match none or one or more different patterns associated with the various faults and/or other alternate modes 32.

Suitably, upon rewriting (or editing) of a model 22 to include alternate modes (i.e., to achieve the corresponding augmented model 42), the description of and/or code for each applicable alternate mode may be injected or otherwise inserted into the model. For example, that description or code may be obtained from the applicable alternate modes 32 and may include one or more equations and/or functions which represent and/or model the alternate mode in question. In practice, every model class definition which contains faults or alternate modes is replaced with a new class definition, e.g., a Modelica model class subsuming the original model class and adding behavior to allow simulation of the faults and/or alternate modes. Additionally, the augmented model 42 is provided with a control mechanism and/or suitable code to permit the selection of the particular mode in which the model 42 will operate for a given simulation. That is to say, the aforementioned control mechanism and/or code allows the augmented model 42 to be selectively run in any one of the modes, be it the nominal mode from the original model 22 or one of the alternate modes added by the rewrite/editing. In this way, alternative dynamics are enabled for each operating mode.

For example, an input model 22 of a capacitor may look something like the following (written in the Modelica language).

```
     model Capacitor
            extends Modelica.Electrical.Analog.Interfaces.OnePort;
            parameter Modelica.Slunits.Capacitance C;
     equation
            i = C*der(v);
     end Capacitor;
```

Accordingly, the output augmented model 42 (also written in the Modelica language) generated from the foregoing input model 22 may look something like the following.

```
 model Capacitor
     import FAME;
     // locally defined classes in Capacitor
     final encapsulated type FAME_OperatingModes =
            enumeration(Nominal, Drift, Electrical_Short,
                        Electrical_Leak, Electrical_Break);
                        // components of Capacitor
     Modelica.Slunits.Voltage v;
     Modelica.Electrical.Analog.Interfaces.PositivePin p;
     FAME.DynamicDampers.ElectricalWithoutConnectEquations_damper_p;
     parameter Modelica.Slunits.Capacitance C;
     Modelica.Electrical.Analog.Interfaces.NegativePin n;
     FAME.DynamicDampers.ElectricalWithoutConnectEquations_damper_n;
     Modelica.Slunits.Current i "Current flowing from pin p to pin n";
     FAME.DynamicBridges.Electrical_bridge_p_n;
     parameter FAME_OperatingModes FAME_operating_mode=
            FAME_OperatingModes.Nominal;
     Modelica.Blocks.Interfaces.RealInput FAME _fault_amount;
     protected
     Modelica.Slunits.Capacitance FAME_C;
     // algorithms and equations of Capacitor
     equation
     i = FAME_C*der(v);
     v = _damper_p.port_b.v-_damper_n.port_b.v;
     0 = _damper_p.port_b.i+_damper_n.port_b.i;
     i = _damper_p.port_b.i;
     connect(p,_damper_p.port_a);
     FAME_C = C*(1.0-FAME_fault_amount);
     connect(n,_damper_n.port_a);
     connect(p,_bridge_p_n.port_a);
     connect(_bridge_p_n.port_b,n);
     if FAME_operating_mode==FAME_OperatingModes.Nominal then
            FAME_fault_amount = 0.0;
     end if;
     if FAME_operating_mode==FAME_OperatingModes.Nominal then
            _damper_p.damping = 0.0;
            _damper_n.damping = 0.0;
            _bridge_p_n.bridging = 0.0;
     elseif FAME_operating_mode==FAME_OperatingModes.Electrical_Short
     then
            _damper_p.damping = 1.0;
            _damper_n.damping = 1.0;
            _bridge_p_n.bridging = 1.0;
     elseif FAME_operating_mode==FAME_OperatingModes.Electrical_Leak
     then
            _damper_p.damping = FAME_fault_amount;
            _damper_n.damping = FAME_fault_amount;
            _bridge_p_n.bridging = FAME_fault_amount;
     elseif FAME_operating_mode==FAME_OperatingModes.Electrical_Break
     then
            _damper_p.damping = 1.0;
            _damper_n.damping = 1.0;
            _bridge_p_n.bridging = 0.0;
     elseif FAME_operating_mode==FAME_OperatingModes.Drift then
            _damper_p.damping = 0.0;
            _damper_n.damping = 0.0;
            _bridge_p_n.bridging = 0.0;
     end if;
     end Capacitor;
```

More specifically, in the forgoing example, it can be seen that four faults and/or alternate modes were found applicable to the original model 22. In particular, in the augmented model 42, an encapsulated "enumerate" type is defined in which the alternate modes labeled as Drift, Electrical_Short, Electrical_Leak and Electrical_Break are listed along with the Nominal mode. A discrete mode parameter of this new type is defined, defining the mode in which an instance of the class is operating. Accordingly, a conditional equation is then employed and/or written to permit dynamic selection of a particular operating mode. Suitably, a set of equations which apply in each alternate mode is expressed in the appropriate branch of this conditional equation. As the operating mode type is, e.g., a Modelica parameter, the selected branch generally will not change during simulation and compilers can optimize this equation.

Two exemplary approaches are now described for augmenting models in accordance herewith. One approach is based on understanding patterns of power flow through a system built with the modeled components, and has the advantage of working with models specified quite abstractly, and in the face of modeling inconsistencies. Suitably, this approach is augmented and/or enhanced with a manually compiled list of declarative specifications of desired parametric faults and/or alternate modes, which are injected automatically. For example, this can allow one to model faults and/or alternate modes more specifically and precisely.

In one embodiment, the power flow analysis may depend on identification of standard power interfaces represented in the input model 22. Suitably, these are instances of Modelica connector classes and/or the like, e.g., such as the Pin class in Modelica's package of analog electrical interface types. In practice, such power interfaces generally contain two variables, one of an "effort" type, such as "Voltage" or "Pressure," and another of a "flow" type, such as "Current" or "MassFlowRate." In one suitable embodiment, the analysis examines both the directly defined components of the model class as well as components of each inherited class used by the model class. Suitably, every model class definition which contains such an instance is wrapped in a "shell" class definition, which is, e.g., a new Modelica model class containing the original model class, and containing an instance of that model class, as well as instances of each connector component, parameter component and constant component found in that original class.

In addition, the system (e.g., the computer or processor 10) can optionally read in a table of parametric faults and/or alternate modes, each row of which describes a particular fault or alternate mode in which a supposedly fixed parameter changes during the operation of the component. For each fault or alternate mode therein, the table or row thereof provides the fault/alternate mode, the Modelica class, the specific parameter component of the class, the Modelica type of the parameter, and a Modelica expression describing the change in the parameter as a function of a variable, e.g., such as FAME_fault_amount. Suitably, e.g., the aforementioned table or the like may reside is a file or the like stored or otherwise saved in a memory or other suitable data storage device that is accessible by the computer or processor 10.

In one suitable embodiment, each new shell class connects its instance of a power interface and/or connector component to the original power interface and/or connector component in its instance of the original model class, through an added variable power dissipation component, e.g., which in the nominal mode is set to dissipate no power. For instance, if the original model class is an electrical component, and the power interface instance is an instance of the class Pin, the appropriate power dissipation component may be an instance of FAME.DynamicDampers.Electrical, with the damping parameter set to 0.

Additionally, if the shell class contains multiple power interfaces and/or connector components of the same type, it may also contain variable power conductance components connecting each pair of compatible connector components, nominally set to conduct no power. In general, connector components are deemed "compatible" if they are of the same type, or inherit from the same type. For instance, if the original model class is an electrical component which contains an instance "p" of the connector type PositivePin and an instance "n" of the connector type NegativePin, both of which are subtypes of Pin, there would be generated an instance of FAME.Bridges.Electrical connecting those two instances, with the conductance or bridging amount set to a very small value of Modelica.Constants.eps.

As shown above, the augmented model 42 contains an example of a capacitor model with the aforementioned dampers and bridges added. Suitably, the model transformation process also flattens (removes all hierarchy) the superclasses of the model into the rewritten class, and introduces two new externally visible components, FAME_operating_mode and FAME_fault_amount, as well as an enumerated type giving the possible faults and/or alternate operating modes for this component, FAME_OperatingModes. Suitably, faults and/or other alternate modes which manifest as power flow anomalies can be modeled by a change to these two variables. For example, as shown above in the output augmented model 42, an electrical short may be modeled by setting FAME_operating_mode equal to FAME_OperatingModes.Electrical_Short, and FAME_fault_amount equal to 1.

As shown above, parametric faults and/or other like alternate modes are handled by introducing a new continuous variable, e.g., prefixed with "FAME_". Suitably, an equation is added to set this variable to the value computed by the function specified by the above-mentioned table of parametric faults and/or alternate modes. Accordingly, references to the original parameter are replaced with an expression which references to this new variable. For example, as shown in the above example, the parameter C (in the input model 22) is replaced with the expression C*(1-FAME_fault_amount) (in the output augmented model 42).

In another approach, it is attempted to detect patterns in the dynamics of the model class which indicate its susceptibility to a particular fault and/or the applicability of a particular alternate mode. Where such susceptibility/applicability is detected, the equations describing the dynamics of that model are then rewritten in such a way as to allow that fault/alternate mode to be modeled.

In practice, for each fault and/or alternate mode, a susceptibility/applicability pattern is specified that, when matched by a model class, indicates that the class may exhibit the fault or alternate mode. Suitably, these patterns are defined in a language that can describe the kinds of components the class may have, and how those components are inter-related. For example, to describe the common fault of clutch or brake slippage caused by surface wear, which results in a loss of torque through the clutch or brake, the process may look for model classes which have two variables representing torque, where one of the variables is the product of the other variable and another variable representing a component of friction. For example, this may be represented as:
component (tau1, type="Modelica.Slunits.Torque")
component (tau2, type="Modelica.Slunits.Torque")
component (friction, type="Modelica.Slunits.CoefiicientOfFriction")
equation (eq1, tau1, product (tau2, friction))

Accordingly, it can be deemed that any model class satisfying these four constraints would be subject to this slippage fault mode.

It is to be noted that the names assigned to variables in the patterns are independent of the names assigned to the variables in the Modelica source code. Suitably, the pattern name bindings are preserved in the case of a match to be used in the modification of the model dynamics. In practice, before matching, the Modelica model class is "flattened"; that is, all superclasses are expanded, and all record and connector subcomponents are expanded.

In one suitable embodiment, the pattern language may be fairly simple. For example, there may be simply two operators, "component" and "equation", which can match components and equations, respectively.

For example, the "component" operator suitably may have the form:
- component *cname qualifier-list*
where *cname* is an identifier to be assigned to the matching component (not the name defined by the component declaration), and *qualifier-list* is a comma-separated list of qualifiers which are to be matched for the constraint to be satisfied. For example, two qualifiers which may be specified are "type", which is, e.g., the fully-qualified name of a Modelica class, and "prefix", which is, e.g., the type prefix for the component declaration.

The "equation" operator, for example, may suitably have the form:
- equation *ename cname rhs-expression*
where *ename* is an identifier to be assigned to the matching component, *cname* is bound in one of the "component" operators, and *rhs-expression* defines a partial constraint on the right-hand side of the matching equation.

In practice, instances of *rhs-expression* may be just a *cname,* or built up, e.g., with the following primitives:
- product *cname-or-exp [ cname-or-exp* ... *]* - product of the named components or subexpressions. Other elements, including other components, may be involved in the product; suitably they are ignored.
- sum *cname-or-exp [ cname-or-exp* ... *]* - sum of the named components or subexpressions. Other elements, including other components, may be involved in the sum; suitably they are ignored.
- quotient *numerator-cname-or-exp denominator-cname-or-exp -* an expression formed of the numerator divided by the denominator.
- difference *minuend-cname-or-exp subtrahend-cname-or-exp -* an expression formed of the minuend minus the subtrahend.
- literal *modelica-literal -* a literal Modelica expression.
- function *cname-or-exp [ cname-or-exp* ... *]* - some arbitrary function of the specified *[ cname-or-exp* elements.

In addition to the patterns used to identity susceptible/applicable classes, each fault and/or alternate mode suitably contains a description of an "edit program", used to modify the class to add the ability to simulate that fault. For example, these edit programs may be written in the following primitives:
- add-component *cname type -* add a new component, internally referred to as *cname* (the actual Modelica name for it will be generated by the editor program), of the specified Modelica *type.* This variable's scope will be "protected".
- replace-component *cname1 came2 [ cname ] -* replace instances of the variable referred to by the metaname *cname1* with the variable referred to by the metaname *cname2* in all equations. If the optional *cname* is specified, only modify the equation referred to by that metaname.

- add-equation *ename cname exp -* add a new equation, internally referred to as *ename,* which binds *cname* to the specified *exp.* The operators for *exp* use the same primitives that are defined for the pattern language above.
- remove-equation *ename -* remove the equation referred to by the metavariable *ename.*
- type cname - returns the Modelica type of the variable referred to with the metaname *cname.*

For example, the edit program for the clutch or brake wear fault described earlier may have the form:
add-component (mu-prime, type=type(mu))
add-component (slip-factor, type="Real (min=0.0, max=1.0)")
replace-component (mu, mu-prime)
add-equation (eq2, mu-prime, product (mu, difference (1.0, slip-factor)))

As another example, a complete fault pattern for the fault Electrical_Open (an open circuit) might look this:
component (v , type="Modelica.Slunits.Voltage")
component (i, type="Modelica.Slunits.Current")
equation(eq1, i, function(v))
remove-equation (eq1)
add-equation (eq2, i, literal ("Modelica.Constants.eps"))

In the case of either approach, as referenced above, JModelica, for example, may be employed to implement the model transformation process carried out by the processor 10. As is understood in the art, JModelica is an open-source Modelica tool chain built by Modelon AB. JModelica includes a Java/JastAdd parser for the Modelica language, along with various simulation and analysis tools, written in both Java and Python. In general, JastAdd is a Java-based implementation of Donald E. Knuth's "attribute grammars," in which nodes in an abstract syntax tree (AST) may have "attributes," the values of which are define by "equations." Each attribute may be either "synthesized" (i.e., defined by an equation attached to the node itself), or "inherited" (i.e., defined by an equation in an ancestor node). JastAdd also supports "reference" attributes, which is an attribute that has as its value another node in the AST. This allows arbitrary graphs to be "woven" through the AST. It also allows its attributes to be "parameterized," which means that the "equation" has unbound variables which bound to parameters when the equation is evaluated. It also allows "collection" attributes, i.e., multi-valued attributes the value of which can be contributed to by various other AST nodes. And it supports "circular" reference attributes, which provide a way of breaking referential cycles.

JastAdd is Java-based, so "equations" are implemented as Java methods, and attribute access is via calls to those methods. It also extends Java itself with various constructs, notably "aspects." JastAdd aspects support "intertype declarations" for AST classes. An intertype declaration is a declaration that appears in an aspect file, but that actually belongs to an AST class (like an attribute equation). The JastAdd system reads the aspect files and weaves the intertype declarations into the appropriate AST classes. It supports both "declarative" aspects (i.e., ".jrag" files), and "imperative" aspects (i.e., ".jadd" files). Declarative aspects add new attributes, equations, and rewrites; imperative aspects add only Java methods and variables. Rewrites of the AST can also be specified; they replace an AST node of type A with a node of type B, optionally only when some condition C is true. New AST subtrees can be created and specified as attribute values (i.e., "non-terminal attributes").

In one suitable embodiment, the first of the above-mentioned approaches may be implemented by parsing each file or model 22 of the library 20, e.g., using the JModelica parser. Then, each model class (i.e., non-partial Modelica class definitions with the restriction "model") found in the parse tree is examiner to look for and/or find instances of "power interfaces" and/or connector classes. For example, a search may be made for the following connector classes:
Modelica.Electrical.Analog.Interfaces.Pin
Modelica.Mechanics.Rotational.Interfaces.Flange_a
Modelica.Mechanics.Rotational.Interfaces.Flange_b
Modelica.Mechanics.Translational.Interfaces.Flange_a
Modelica.Mechanics.Translational.Interfaces.Flange_b
Modelica.Fluid.Interfaces. FluidPort
Modelica.Thermal.HeatTransfer.Interfaces.HeatPort

If any of the above components or the like are found, a new parse tree is created for a replacement class for the model class, incorporating the changes described above. Accordingly, using, e.g., a JastAdd rewrite, the model class's parse tree is replaced with the new parse tree. Finally, the JModelica "FormattedPrettyPrint" aspect and/or capability, for example, is used to recreate and/or rewrite and/or otherwise output the now-fault-enabled Modelica source code and/or library file for the augmented model from the AST.

In another exemplary embodiment, fault and/or alternate mode injection is implemented in accordance with the second of the above-described approaches. In this case, each generic fault or alternate mode, e.g., such as an "electrical short", is modeled with an aspect which provides a subclass of a more generic class, e.g., "Fault". Each Fault or alternate mode subclass provides a predicate, e.g., such as:
static boolean may_occur_with (FullClassDecl klass);
which, given a FullClassDecl (a node in the JModelica AST which represents the definition of a Modelica class), says whether that FullClassDecl might be susceptible to this fault (or the alternate mode may otherwise be applicable).

Suitably, the implementation of the "may_occur_with" predicate is dependent on matching some pattern defined for the fault/alternate mode against the parse of the model, as given by the FullClassDecl node of the AST.

In addition, each Fault or alternate mode subclass suitably contributes an instance of itself to the "possibleFaults" collection attribute on FullClassDecl, if that FullClassDecl is susceptible to it, using, e.g., the JastAdd "contributes" mechanism. For instance, for a Fault subclass ElectricalShort, it might look like the following:

```
     FullClassDecl contributes (ElectricalShort(this))
            when (ElectricalShort.may_occur_with(this))
            to FullClassDecl.possibleFaults()
            for this;
```

In practice, more fault/alternate modes can be added by adding aspects to the collection of fault aspects, and re-compiling the program.

Suitably, to inject the faults and/or alternate modes, JModelica FullClassDecl node type is extended to include a number of additional attributes, e.g., in the following manner:

```
      coll Set <Fault> FullClassDecl.possibleFaults()
            [new HashSet<Fault>()] with add root List;
     syn lazy boolean ClassDecl.faultEligible() = false;
     syn lazy boolean FullClassDecl.faultEligible() {
            if (isUnknown() || hasPartial()
                  |||| !(getRestriction().isBlock() || getRestriction().isModel())) {
                  return false;
            }
            return (possibleFaults().size() > 0);
     }
```

Then, the "rewrite" capability of JastAdd, for example, may be used to re-write the AST representing the model, the FullClassDecl node, to add fault behavior to that model. For example, the rewrite rule may look something like the following:

```
 rewrite FullClassDecl {
     when (faultEligible()) // faults possible for this type?
     to FullClassDecl {
            for (Fault f : possibleFaults()) {
                  // add an enumeration value for each fault this component
                  // is susceptible to
                  List<ComponentDecl> fault_comps = f.fault_components();
                  if (fault_comps != null)
                        for (ComponentDecl c : fault_comps) {
                               addComponentDeclNoTransform(c);
                        }
            }
            // rewrite the equations as an if-equation
            setEquationList(rewriteEquationsToAddFaults());
            return this;
     }
     }
```

Suitably, this rewrite may be applied automatically as part of the parsing process, where appropriate, which will result in the fault/alternate behavior clauses being injected into the parse of the model. In practice, the equation re-writing method, rewriteEquationsToAddFaults(), takes the nominal equations for the model, and wraps them in one branch of a Modelica if-equation for that case, then adds additional branches to the if-equation for each possible fault/alternate mode, along with the equations for that fault/alternate mode. In one suitable embodiment, those fault/alternate equations may be obtained by calling a method on the Fault and/or alternate subclass instance. In Modelica, an if-equation is a common way of implementing a conditional equation.

Finally, the JModelica "FormattedPrettyPrint" aspect and/or capability, for example, may be used to recreate the now-fault-enabled Modelica source code for the model from the AST.

In the case of either approach, in one suitable embodiment, the overall program for injecting faults and/or alternate modes into the models may look something like the following (in pseudo-code):

```
     for file in recurseOver (libraryTree):
            outputFile = figureOutputName (outputDir, file)
            parsedVersion = parseFile (file)
            prettyPrint (parsedVersion, outputFile)
```

Once the faults and/or alternate modes have been added, regular Modelica simulation can be used to assess their effects. In practice, the augmented models can be used for a wide variety of diagnostic applications. Suitably, all the augmented models are written in standard Modelica. Thus, the initial values, parameters and fault/alternate modes can all be set in a Modelica wrapper. For example, some uses of the new models for both design and diagnostic purposes include, but are not limited to:
- Given a set of initial conditions, parameter values and faults, determine whether a system requirement is met.
- Given a set of initial conditions, faults and component ages, determine the conditional probability that the system meets a requirement.
- Given a set of initial conditions, faults, observations, and ages for all but one of the components, determine the age of the remaining component.
- Standard model-based diagnosis.
- Fault mode and effects analysis.
- Fault mode and effects criticality analysis.
- Determine which component(s) damage most effects whether system meets requirements.
- Determining MTTF.

The above methods and/or apparatus have been described with respect to particular embodiments. It is to be appreciated, however, that certain modifications and/or alteration are also contemplated.

In any event, it is to be appreciated that in connection with the particular exemplary embodiment(s) presented herein certain structural and/or function features are described as being incorporated in defined elements and/or components. However, it is contemplated that these features may, to the same or similar benefit, also likewise be incorporated in other elements and/or components where appropriate. It is also to be appreciated that different aspects of the exemplary embodiments may be selectively employed as appropriate to achieve other alternate embodiments suited for desired applications, the other alternate embodiments thereby realizing the respective advantages of the aspects incorporated therein.

It is also to be appreciated that any one or more of the particular tasks, steps, processes, methods, functions, elements and/or components described herein may suitably be implemented via hardware, software, firmware or a combination thereof. In particular, the processor 10 may be embodied by a computer or other electronic data processing device that is configured and/or otherwise provisioned to perform one or more of the tasks, steps, processes, methods and/or functions described herein. For example, a computer or other electronic data processing device embodying the processor 10 may be provided, supplied and/or programmed with a suitable listing of code (e.g., such as source code, interpretive code, object code, directly executable code, and so forth) or other like instructions or software or firmware, such that when run and/or executed by the computer or other electronic data processing device one or more of the tasks, steps, processes, methods and/or functions described herein are completed or otherwise performed. Suitably, the listing of code or other like instructions or software or firmware is implemented as and/or recorded, stored, contained or included in and/or on a non-transitory computer and/or machine readable storage medium or media so as to be providable to and/or executable by the computer or other electronic data processing device. For example, suitable storage mediums and/or media can include but are not limited to: floppy disks, flexible disks, hard disks, magnetic tape, or any other magnetic storage medium or media, CD-ROM, DVD, optical disks, or any other optical medium or media, a RAM, a ROM, a PROM, an EPROM, a FLASH-EPROM, or other memory or chip or cartridge, or any other tangible medium or media from which a computer or machine or electronic data processing device can read and use. In essence, as used herein, non-transitory computer-readable and/or machine-readable mediums and/or media comprise all computer-readable and/or machine-readable mediums and/or media except for a transitory, propagating signal.

Optionally, any one or more of the particular tasks, steps, processes, methods, functions, elements and/or components described herein may be implemented on and/or embodiment in one or more general purpose computers, special purpose computer(s), a programmed microprocessor or microcontroller and peripheral integrated circuit elements, an ASIC or other integrated circuit, a digital signal processor, a hardwired electronic or logic circuit such as a discrete element circuit, a programmable logic device such as a PLD, PLA, FPGA, Graphical card CPU (GPU), or PAL, or the like. In general, any device, capable of implementing a finite state machine that is in turn capable of implementing the respective tasks, steps, processes, methods and/or functions described herein can be used.

Additionally, it is to be appreciated that certain elements described herein as incorporated together may under suitable circumstances be stand-alone elements or otherwise divided. Similarly, a plurality of particular functions described as being carried out by one particular element may be carried out by a plurality of distinct elements acting independently to carry out individual functions, or certain individual functions may be split-up and carried out by a plurality of distinct elements acting in concert. Alternately, some elements or components otherwise described and/or shown herein as distinct from one another may be physically or functionally combined where appropriate.

In short, the present specification has been set forth with reference to preferred embodiments. Obviously, modifications and alterations will occur to others upon reading and understanding the present specification. It is intended that the invention be construed as including all such modifications and alterations insofar as they come within the scope of the appended claims or the equivalents thereof.

## Claims

1. A method for automatically generating an augmented model of a physical component, said method comprising:
reading an input model into a processor, said input model describing a
nominal mode of operation for a physical component modeled by said input model;
parsing with said processor said input model to generate a parse thereof;
analyzing with said processor the parse of said input model; and
automatically writing with said processor an augmented model for the
physical component from said input model based on said analysis, said augmented model describing the nominal mode of operation for the modeled physical component and at least one alternate mode of operation for the modeled physical component which is ?different from the nominal mode of operation.

2. The method of claim 1, wherein said analyzing comprises:
searching said parse for instances of at least one of power interfaces or
connector classes, such that if at least one of a power interface or a connector class is found, then an alternate mode related thereto is described in the augmented model.

3. The method of claim 1, wherein said analyzing comprises:
detecting a pattern in said parse which matches a target pattern
associated with the alternate mode to be described in said augmented model, such that if a pattern is detected which matches said target pattern, then the associated alternate mode is described in the augmented model.

4. The method of claim 1, wherein said writing comprises:
providing a control mechanism by which one of the modes of operation
described in the augment model is selected for use in a simulation employing said augmented model.

5. The method of claim 1, wherein said nominal mode of operation corresponds to a correct behavior of the modeled component and said alternate mode of operation corresponds to a faulty behavior of the modeled component.

6. A system for automatically generating an augmented model of a physical component, said system comprising:
a processor operative to:
read in an input model, said input model describing a nominal mode of
operation for a physical component modeled by said input model;
parse said input model to generate a parse thereof;
analyze the parse of said input model; and
automatically write an augmented model for the physical component from
said input model based on said analysis, said augmented model describing the nominal mode of operation for the modeled physical component and at least one alternate mode of operation for the modeled physical component which is different from the nominal mode of operation.

7. The system of claim 6, wherein said analyzing comprises:
searching said parse for instances of at least one of power interfaces or
connector classes, such that if at least one of a power interface or a connector class is found, then an alternate mode related thereto is described in the augmented model.

8. The system of claim 6, wherein said analyzing comprises:
detecting a pattern in said parse which matches a target pattern
associated with the alternate mode to be described in said augmented model, such that if a pattern is detected which matches said target pattern, then the associated alternate mode is described in the augmented model.

9. The system of claim 6, wherein said writing comprises:
providing a control mechanism by which one of the modes of operation
described in the augment model is selected for use in a simulation employing said augmented model.

10. The system of claim 6, wherein said nominal mode of operation corresponds to a correct behavior of the modeled component and said alternate mode of operation corresponds to a faulty behavior of the modeled component.
